# EUROPEAN PATENT APPLICATION

(11) **EP 4 815 649 A1**
(43) Date of publication of application: **30.09.2026**
(21) Application number: 25166218.5
(22) Date of filing: 26.03.2025
(51) Int. Cl.: H05K 7/14

(54) **SUSPENSION ARRANGEMENT FOR A HIGH VOLTAGE VALVE UNIT**

(71) Applicant: Hitachi Energy Ltd, 8050 Zürich (CH)
(72) Inventor: Van den Brink, Bram, 771 51 Ludvika (SE); Andersson, Olov, 771 34 Ludvika (SE); Alam, Minhaj, 633 62 Eskilstuna (SE); Backström, Daniel, 724 61 Västerås (SE); Örtenmark, Patrik, 731 97 Köping (SE)
(74) Representative: AWA Sweden AB

(57) **Abstract**

A suspension arrangement for suspending a high voltage valve unit from a load carrying support structure is provided. The suspension arrangement comprises a rigid suspending insulator, a first coupling device, a second coupling device and at least one rotational damper. The rigid suspending insulator is configured to suspend the valve unit from the support structure. The first coupling device is configured to connect the suspending insulator to the support structure. The first coupling device is configured to allow rotation of the suspending insulator relative the support structure about two first perpendicular and substantially horizontal axes. The second coupling device is configured to connect the suspending insulator to the valve unit. The second coupling device is configured to allow rotation of the valve unit relative the suspending insulator about structure about two second perpendicular and substantially horizontal axes. The at least one rotational damper is arranged at the first coupling device to damp relative rotations between the suspending insulator and the support structure about the two first axes, or the at least one rotational damper is arranged at the second coupling device to damp relative rotations between the valve unit and the suspending insulator about the two second axes.

## Description

### Technical field

The present disclosure relates generally to the field of high voltage technology. More specifically, it relates to a suspension arrangement for a high voltage valve unit.

### Background

High voltage valve units are often arranged in valve halls. The voltage valve units may be arranged standing on a support structure or hanging from a support structure.

Standing converter valves face structural stress during high seismic ground motion. Damping solutions are necessary in order to meet the safety requirements in regions of high seismic activity. In areas with little seismic activity, standing converter valves may be mounted directly on the ground or floor. In order to withstand some ground movement, converter valves may be mounted on a resilient platform or base. However, such arrangements usually cannot handle more significant ground movement or acceleration.

In other configurations, converter valves are hung from the ceiling. In the event of seismic acceleration, the valve is allowed to swing more or less freely, acting as a pendulum. Such hanging structures may operate at a low natural frequency, which may lower the stress on the converter valve. To reduce the motion of hanging valve units, the units are often further supported by rigid post insulators attached between the floor and the hanging valve unit.

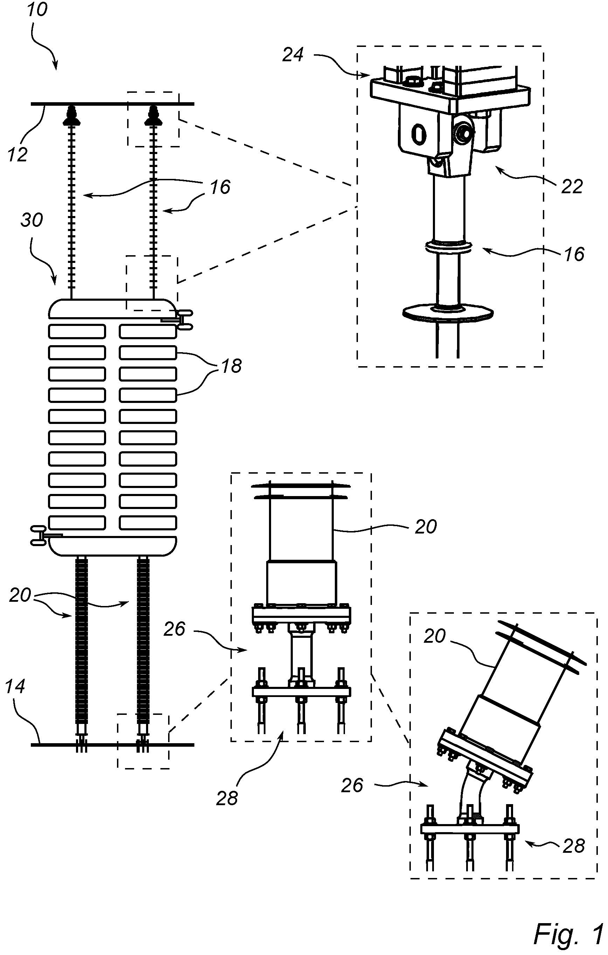

A typical hanging valve unit arrangement 10 is illustrated in Figure 1. A high voltage valve unit 30 comprising a plurality of converter valves 18 is suspended from a support structure 12 in the ceiling using tensile rod insulators 16. The tensile rod insulators 16 are connected to a fastening 24 of the support structure 12 and to the valve unit 30 by means of joints 22. The joints 22 may for example be universal joints which allow rotation around two perpendicular and horizontal axes. The tensile rod insulators 16 may allow the high voltage valve unit 30 to swing from the support structure 12. To prevent or reduce the swinging motion, the suspended valve unit 30 is secured (via a fastening 28) to the floor 14 by post insulators 20 and dampers 26. During an earthquake, the dampers 26 may deform or otherwise absorb the mechanical seismic energy, preventing or reducing the swinging movement of the valve units 30.

However, these arrangements have drawbacks. For example, to withstand seismic motion, the conventional arrangements require two connection interfaces between the valve unit and the valve hall. In a valve hall including valve units of different length, i.e., including a different number of valve layers 18, the length of either the suspension arrangement or the damping arrangement must be adapted to each valve unit.

Furthermore, each connection between the valve hall and the valve unit reduces the electrical gap factor. Thus, when then the valve unit is connected to, e.g., the ceiling, the space between the valve unit and the ceiling must be larger to reach the required electrical isolation. Connecting the valve units to both the ceiling and the floor may increase the overall height of the valve hall.

There is therefore a need for improved arrangements for converter valves in areas of seismic activity.

### Summary

It is an object of the present invention to overcome at least some of the above-mentioned drawbacks, and to provide an improved arrangement of valve units inside e.g., a valve hall.

This and other objects are achieved by means of a suspension arrangement as defined in the appended independent claim. Other embodiments are defined by the dependent claims.

According to a first aspect of the present disclosure, a suspension arrangement for suspending a high-voltage valve unit from a load carrying support structure is provided. The suspension arrangement comprises a rigid suspending insulator configured to suspend the valve unit from the support structure. The suspension arrangement further comprises a first coupling device. The first coupling device is configured to connect the rigid suspending insulator to the support structure. The first coupling device is further configured to allow rotation of the rigid suspending insulator relative the support structure about two first perpendicular and substantially horizontal axes. The suspension arrangement further comprises a second coupling device. The second coupling device is configured to connect the rigid suspending insulator to the valve unit. The second coupling device is further configured to allow rotation of the valve unit relative the rigid suspending insulator about two second perpendicular and substantially horizontal axes. The suspension arrangement further comprises at least one rotational damper. The at least one rotational damper is arranged at the first coupling device to damp relative rotations between the rigid suspending insulator and the support structure about the two first axes. Alternatively, or additionally, the at least one rotational damper is arranged at the second coupling device to damp relative rotations between the valve unit and the rigid suspending insulator about the two second axes.

The suspension arrangement of the present disclosure integrates the damping in the suspension arrangement of the valve unit.

A load carrying support structure may comprise, or be arranged in, a ceiling of, e.g., a valve hall. The first coupling devices are configured to be connected to such a load carrying support structure.

The present suspension arrangement includes a rigid suspending insulator connected to a first coupling device and a second coupling device. The rigid suspending insulator is an electrical insulator. The first coupling device allows relative rotation of the rigid suspending insulator and the support structure about two first perpendicular and substantially horizontal axes. The second coupling device allows relative rotation between the valve unit and the rigid suspending insulator about two second perpendicular and substantially horizontal axes. The two first perpendicular and substantially horizontal axes of the first coupling device may be the same or different from the two second perpendicular and substantially horizontal axes of the second coupling device. The suspension arrangement may therefore allow (some) swinging movement of the valve unit relative to the load carrying support structure.

However, a rigid suspending insulator may, unlike a tensile rod insulator, resist moment forces. Thus, by including a rigid suspending insulator in the suspension arrangement, a rotational damper may be arranged in the suspension arrangement itself, to dampen, prevent or reduce swinging motions of the valve unit in case of a seismic event.

By including the rotational damper included in the suspension arrangement, the need for also connecting the valve unit to the floor of the valve hall may be removed. By removing the physical connection between the high voltage valve unit and the floor, the gap factor between the high voltage valve unit and the floor of a valve hall may be increased. This may allow the high voltage valve unit to be arranged closer to the floor, which in turn may allow for a lower total height of the valve hall.

Moreover, the present suspension arrangement may be used for high-voltage valve units of different lengths, i.e., with different number of valve layers.

According to some embodiments, the first coupling device may comprise a first universal joint. The second coupling device may comprise a second universal joint.

A universal joint is a joint for coupling two rigid elements. A universal joint allows rotational movement between two rigid elements about two perpendicular axes. A universal joint may also be referred to as a cardan joint, a Hooke joint, a Spicer joint or a Polhem joint.

According to some embodiments, the first coupling device may comprise a first ball joint. The second coupling device may comprise a second ball joint.

A ball joint may also be used for coupling two rigid elements. A ball joint may also allow rotational movement between the two rigid elements about two axes.

According to some embodiments, the rotational damper may be separate from the first coupling device. The rotational damper may be arranged in parallel with the first coupling device. Alternatively, or additionally, the rotational damper may be separate from the second coupling device. The rotational damper may be arranged in parallel with the second coupling device.

By arranging the rotational damper in parallel with the coupling device in question, the rotational damper may more easily and safely be replaced after a seismic event or at its end of life, without removing the coupling device.

According to some embodiments, the rotational damper may be an integral part of the first coupling device or the second coupling device.

According to some embodiments, the rotational damper may comprise a yield damper. A yield damper is a device which is configured to undergo plastic deformation when subject to a force, thereby absorbing energy of, e.g., a seismic event and suppressing unwanted movement.

According to some embodiments, the rotational damper may comprise a viscous damper. A viscous damper converts kinetic energy into heat using a viscous fluid, such as silicone.

According to some embodiments, the rotational damper may comprise a friction damper. A friction damper is a device used to dissipate energy through the dry friction between two surfaces, thereby converting kinetic energy to thermal energy.

According to some embodiments, the rigid suspending insulator may be a post insulator. The rigid suspending insulator may be a hollow core post insulator or a solid core post insulator.

According to some embodiments at least one of the first coupling device and the second coupling device may comprise a universal joint connected to a first support member and a second support member. The universal joint may allow relative rotation between the two support members about a first axis and a second axis perpendicular to the first axis. The at least one rotational damper may comprise four damping elements. Each damping element may comprise a base section, a connector section, and a yielding section extending between the base section and the connector section. The yielding section may be configured to plastically deform by a relative rotation between the base section and the connector section. A first pair of the damping elements may be arranged on opposite sides of the universal joint along the first axis. The base sections of each of the first pair of damping elements may be fastened to the first support member. A second pair of the damping elements may be arranged on opposite sides of the universal joint along the second axis. The base sections of each of the second pair of damping elements may be fastened to the second support member. The connector sections of each of the first pair of damping elements may be fastened to the connector sections of each of the second pair of damping elements such that the connector sections of the four damping elements form a rigid loop around the universal joint.

The four damping elements may be said to form a rotation damping structure. The four damping elements may be arranged in parallel with the universal joint. Thus, the four damping elements may easily be replaced after a seismic event.

The rotation damping structure comprising the four damping elements may mimic the configuration of a universal joint. A universal joint allows movement about two perpendicular axes. The rotation damping structure of the present embodiment may decouple the damping of rotational motion about the two axes. The first pair of damping elements may be arranged to damp rotation about the first axis. The second pair of damping elements may be arranged to damp rotation about the second axis.

Since each of the damping elements is only subject to motion about one axis, the shape of the damping element may be optimized for that axis alone.

The yielding sections of the first pair of damping elements may both be aligned with the first axis. The yielding sections of the second pair of damping elements may both be aligned with the second axis.

According to some embodiments the rigid suspending insulator may be one of at least two rigid suspending insulators. Each of the at least two rigid suspending insulators may be configured to suspend the valve unit from the support structure. Each rigid suspending insulator may be connected to a first coupling device configured to connect the rigid suspending insulator to the support structure. For each rigid suspending insulator, the first coupling device may be configured to allow rotation of the rigid suspending insulator relative the support structure about two first separate and substantially horizontal axes. Each rigid suspending insulator may be connected to a second coupling device configured to connect the rigid suspending insulator to the valve unit. For each rigid suspending insulator, the second coupling device may be configured to allow rotation of the valve unit relative the rigid suspending insulator about two second separate and substantially horizontal axes. For each rigid suspending insulator, at least one rotational damper may be arranged at the first coupling device to damp relative rotations between the rigid suspending insulator and the support structure about the two first axes. Alternatively, or additionally, for each rigid insulator, the at least one rotational damper may be arranged at the second coupling device to damp relative rotations between the valve unit and the rigid suspending insulator about the two second axes.

According to some embodiments, the suspension arrangement may comprise four rigid suspending insulators configured to suspend the valve unit from the support structure.

According to some embodiments, for each suspending insulator, the at least one rotational damper may be arranged at the first coupling device to damp relative rotations between the suspending insulator and the support structure about the two first axes. Alternatively, or additionally, for each suspending insulator, the at least one rotational damper may be arranged at the second coupling device to damp relative rotations between the valve unit and the suspending insulator about the two second axes.

According to some embodiments, the suspension arrangement may further comprise at least one further suspending insulator configured to suspend the valve unit from the support structure. The at least one further suspending insulator may be arranged without a corresponding rotational damper.

The at least one further suspending insulator may be a rigid suspending insulator or a tensile rod insulator.

According to a second aspect of the present disclosure, a high-voltage system is provided. The high-voltage system comprises high-voltage valve unit and a suspension arrangement according to the first aspect of the present disclosure for suspending the valve unit from a load carrying support structure.

The high-voltage system may for example be installed from a load carrying support structure in, e.g., a valve hall.

It is noted that other embodiments using all possible combinations of features recited in the above-described embodiments may be envisaged. Thus, the present disclosure also relates to all possible combinations of features mentioned herein.

### Brief description of drawings

Exemplifying embodiments will now be described in more detail, with reference to the following appended drawings:
Figure 1 is a schematic illustration of a conventional high-voltage system according to prior solutions;
Figure 2 is a schematic illustration of a high-voltage in accordance with some embodiments of the present disclosure;
Figure 3 is an illustration of a coupling device in accordance with some embodiments;
Figure 4 is an illustration of a coupling device equipped with a rotational damper, in accordance with some embodiments;
Figure 5 is an illustration of a coupling device equipped with a rotational damper, in accordance with some embodiments;
Figure 6 is an illustration of a coupling device equipped with a rotational damper, in accordance with some embodiments;
Figure 7 is an illustration of a suspension arrangement in accordance with some embodiments;
Figure 8 is an illustration of a suspension arrangement in accordance with some embodiments; and
Figure 9 is an illustration of a suspension arrangement in accordance with some embodiments.

As illustrated in the figures, the sizes of the elements and regions may be exaggerated for illustrative purposes and, thus, are provided to illustrate the general structures of the embodiments. Like reference numerals refer to like elements throughout.

### Detailed description

Exemplifying embodiments will now be described more fully hereinafter with reference to the accompanying drawings in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

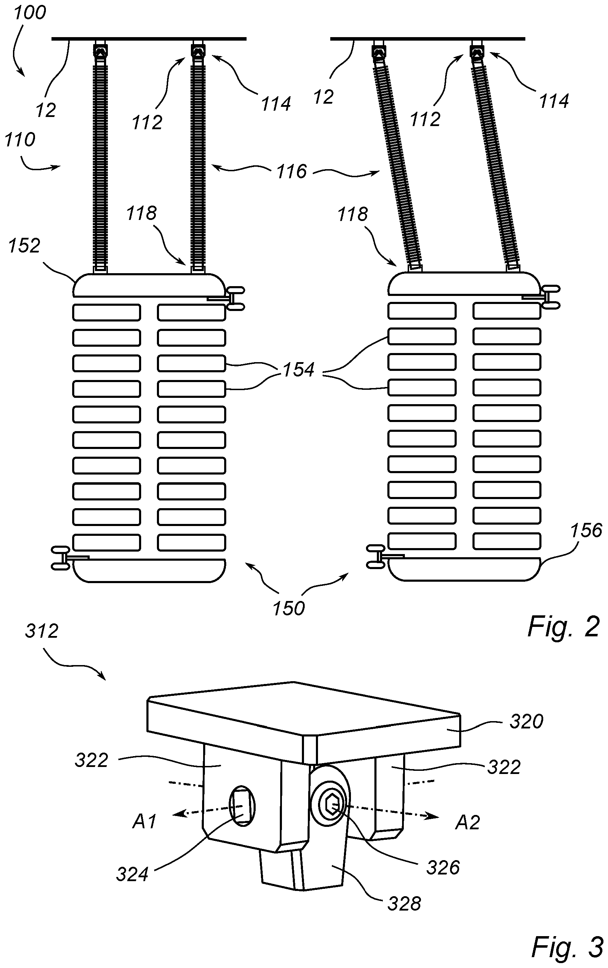

With reference to Figure 2, a high voltage system 100 in accordance with some embodiments will be described. The high voltage system 100 comprises a high voltage valve unit 150 suspended from a load carrying support structure 12 by a suspension arrangement 110. Figure 2 illustrates the high voltage system 100 in a side view. To the left of the Figure, the high voltage system 100 is illustrated in a stationary, resting position, in which the high voltage valve unit is hanging vertically from the load carrying support structure 12. During a seismic event, seismic waves may cause the high voltage valve unit 150 to sway or swing, as is illustrated to the right of Figure 2.

The high voltage valve unit 150 includes a plurality of converter valves 154. The high voltage valve unit 150 further comprises two electrical shields 152, 156 arranged at the top and the bottom of the high voltage system.

The suspension arrangement 110 is arranged to suspend the high voltage valve unit 150 from the load carrying support structure 12. The load carrying support structure 12 may for example comprise or be arranged in a ceiling of a valve hall.

The suspension arrangement 110 comprises a rigid suspending insulator 116. Specifically, in Figure 2, the suspension arrangement may comprise four rigid suspending insulators 116, arranged connected to a respective corner of the upper shield 152. Each of the rigid suspending insulators 116 is connected to the support structure 12 through a respective first coupling device 112. Each of the first coupling devices may allow rotation of corresponding rigid suspending insulator 116 about two first perpendicular and substantially horizontal axes in relation to the support structure 12. Each of the rigid suspending insulators 116 is connected to the valve unit 150 through a respective second coupling device 118. Each of the second coupling devices 118 may allow relative rotation between the valve unit 150 and the rigid suspending insulator 116 about two second perpendicular and substantially horizontal axes.

Each of the first coupling devices 112 is equipped with a rotational damper 114. The rotational damper 114 may resist rotational movement of the rigid suspending insulators 116 relative to the support structure 12. Thus, the rotational dampers 114 may dampen a swinging movement of the valve unit 150 caused by seismic activity. While, in Figure 2, each of the rigid suspending insulators 116 is equipped with a rotational damper 114, one or more of the suspending insulator may be arranged without a damper 114. Further, while in Figure 2, the rotational dampers 114 are all arranged at the respective first coupling device 112, it is submitted that one or more, such as all, of the rotational dampers 114 may be arranged at the respective second coupling device 118.

Figure 3 is an illustration of a coupling device 312 in accordance with some embodiments. The coupling device 312 may be used as a first coupling device 112 and/or as a second coupling device 118 in a suspension arrangement 110 as illustrated in Figure 2.

The coupling device 312 is an example of a universal joint. A universal joint allows movement between two rigid elements about a first axis A1 and a second axis A2. The first and second axes A1, A2 are perpendicular. The coupling device 312 comprises a first support 320, which may for example be connected to a support structure 12 or a valve unit 150 as illustrated in Figure 2. Two ears 322 extend from the support 320. A first shaft or axle 324 extends between openings in the two ears 322. The first axle 324 is rotatable in relation to the two ears 322 and defines the first rotational axis A1. A second axle 326 or shaft is connected to the first axle 324. The second axle 326 may rotate together with the first axle 324 about the first axis A1. The first and second axles 324, 326 may be connected to form a cross shape. A second support 328 is rotationally attached to the second axle 326. The second support may rotate about the second axle 326, such that the second axle 326 defines the second rotational axis A2. The second support 328 may for example be connected to a rigid suspending insulator 116 as illustrated in Figure 2.

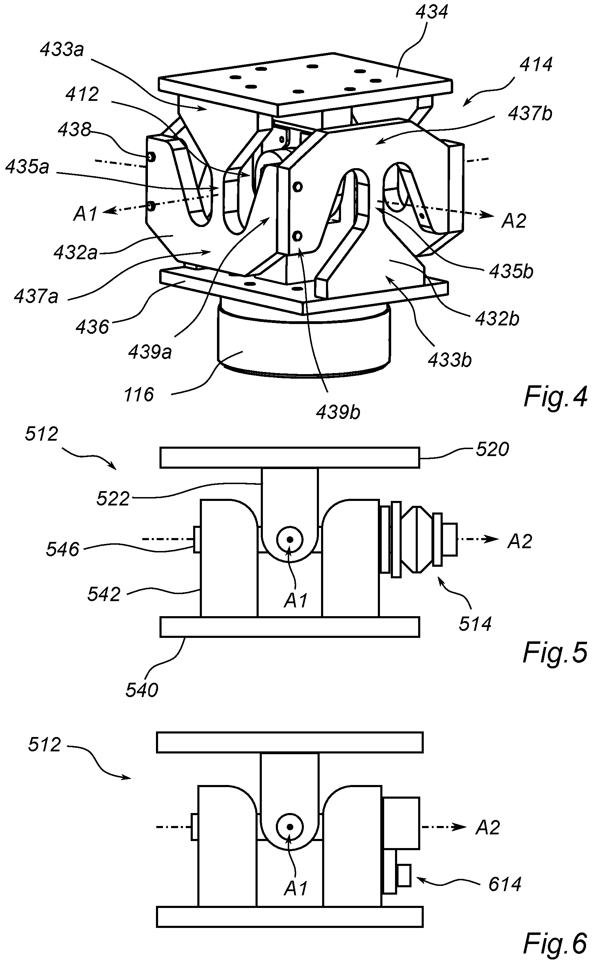

Figure 4 is an illustration of a coupling device 412 equipped with a yield damper 414. Specifically, the coupling device 412 is a universal joint, such as the universal joint 312 described above with reference to Figure 3.

The universal joint 412 is connected to a first support member 434 and a second support member 436. The support members 434, 436 may for example be connected to a load carrying support structure 12, a rigid suspending insulator 116 or a high voltage valve unit 150 as described above with reference to Figure 2.

The universal joint 412 allows relative rotation between the two support members 434, 436 about a first axis A1 and a second axis A2. The two axes A1, A2 are perpendicular.

The yield damper 414 is a damping arrangement comprising four damping elements 432a, 432b arranged forming a rigid ring around the universal joint 412. Each of the damping elements comprise a base section 433a, 433b, a connector section 437a, 437b, and a yielding section 435a, 435b extending between the base section 433a, 433b and the connector section 437a, 437b. The damping elements 432a, 432b are arranged in two pairs. A first pair of the damping elements 432a are arranged on opposite sides of the universal joint 412 along the first axis A1. The base sections 433a of the first pair of damping elements 432a are fastened to the first support member 434. The second pair of damping elements 432b are arranged on opposite sides of the universal joint 412 along the second axis A2. The second pair of damping elements 432b is arranged upside down in relation to the first pair of damping elements 432a. The base sections 433b of each of the second pair of damping elements 432b are fastened to the second support member 436.

The connector sections 437a of each of the first pair of damping elements 432a are fastened to the connector sections 437b of each of the second pair of damping elements 432b. Specifically, a side portion 439a of the connector section 437a of each of the first pair of damping elements 432a is connected to a side portion 439b of the connector section 437b of each of the second pair of damping elements 432b. In Figure 4, the side portions 439a, 439b are connected by fastening means 438, such as screws. The connector sections 437a, 437b of the four damping elements form a rigid loop around the universal joint 412.

The yielding sections 435a, 435b are configured to plastically deform by a relative rotation between the base section 433a, 433b and the connector section 437a, 437b of the damper element 432a, 432b. The arrangement of the damping elements 432a, 432b provides that any rotation between the between the two support members 434, 436 about the first axis A1 is dampened by the first pair of damping elements 432a. Specifically, upon a rotational force applied about the first axis A1, the yielding sections 435a of the first pair of damping elements 432a will first undergo a short period of elastic deformation, followed by a plastic deformation. The plastic deformation of the yielding section 435a will absorb the energy from the rotational force, thereby damping rotational movement caused by the force. Similarly, any rotation between the between the two support members 434, 436 about the second axis A2 is dampened by the plastic deformation of the yielding sections 435b of the second pair of damping elements 432b.

The arrangement of the damping elements 432a, 432b provides a decoupling of the damping of rotation about the two axes. As each damping element 432a, 432b is only subject to rotational forces about one of the axes, the damping element 432a, 432b may be optimized to damp rotation about that axis alone. For example, a length, width and/or thickness of the yielding section 435a, 435b may be adapted or selected to damp rotation about the corresponding axis.

Figure 5 is a schematic side view illustration of a coupling device 512 equipped with a friction damper 514. Specifically, the coupling device 512 is a universal joint comprising a first support 520 and a second support 540. From each of the supports 520, 540 two ears 522, 542 extend. A cross-shaped bar 546 extends between openings in each of the two pairs of ears 522, 542. The cross-shaped bar 546 is rotatably arranged in the openings of the first two ears 522, allowing rotation of the cross-shaped bar about a first axis A1 relative to the first support 520. The cross-shaped bar 546 is rotatably arranged in the openings of the second two ears 524, allowing rotation of the cross-shaped bar about a second axis A2 relative to the second support 540. A friction damper 514 is arranged to damp rotation of the second support about the second axis A2. The friction damper 514 comprises a plurality of discs. The friction damper 514 is configured to convert rotational energy about the second axis A2 into heat through dry friction between the discs. The coupling device 512 may be equipped with a corresponding friction damper for damping rotational movement of the first support 520 about the first axis A1.

Figure 6 is a schematic side view illustration of a coupling device 512 equipped with a viscous damper 614. The coupling device 512 may be equivalent to the coupling device 512 described with reference to Figure 5.

The viscous damper 614 is arranged to convert kinetic energy of rotational movement of the second support 540 about the second axis A2 into heat using a viscous fluid. The coupling device may be equipped with a corresponding viscous damper for damping rotational movement of the first support 520 about the first axis A1.

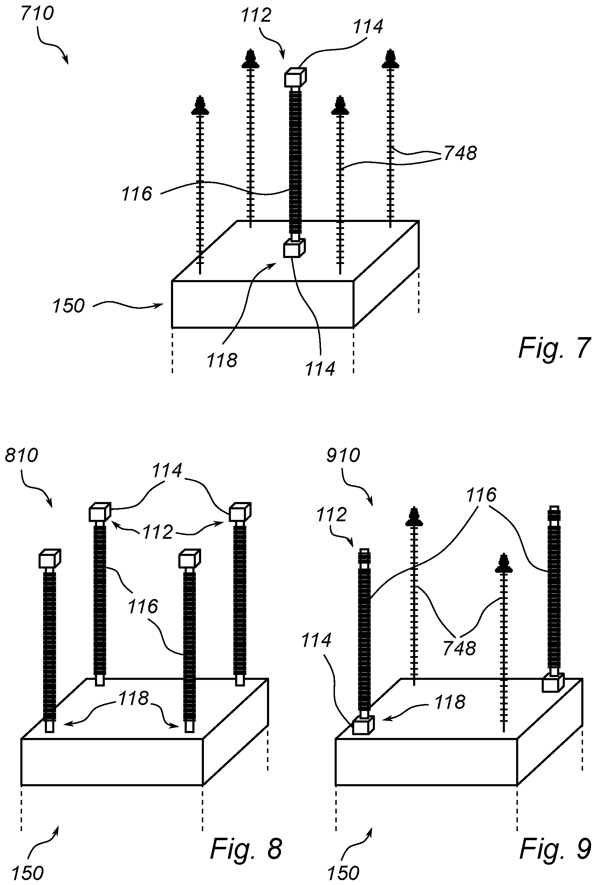

Figure 7 is a perspective view of a suspension arrangement 710 in accordance with some embodiments. The suspension arrangement 710 may be equivalent to the suspension arrangement 110 described above with reference to Figure 2, except in that it comprises a single rigid suspending insulator 116. The suspension arrangement 710 further comprises four tensile rod insulators 748. The tensile rod insulators 748 may be connected to the load carrying support structure (not illustrated) via coupling devices similar to the first coupling device 112. The tensile rod insulators 748 may be connected to the high voltage valve system via coupling devices similar to the second coupling device 118. The tensile rod insulators 748 are electrically insulating and, together with the rigid suspending insulator 116, support the weight of the valve unit 150. However, a tensile rod insulator 748 is bendable and can therefore not resist the moment forces necessary to dampen rotational movement. Therefore, only the rigid suspending insulator 116 is equipped with a rotational damper 114. In Figure 7, the rigid suspending insulator 116 is equipped with two rotational dampers 114, one at each of the first and the second coupling devices 112, 118.

Figure 8 is a perspective view of a suspension arrangement 810 in accordance with some embodiments. The suspension arrangement 710 may be equivalent to the suspension arrangement 110 described above with reference to Figure 2. Specifically, the suspension arrangement 710 comprises four rigid suspension insulators 116 arranged to suspend a high voltage valve unit 150 from a load carrying support structure (not illustrated).

Each of the rigid suspension insulators 116 is equipped with a rotational damper 114, arranged at the respective first coupling device 112, i.e., at the coupling device connecting the rigid suspending insulator 116 to the load carrying support structure.

Figure 9 is a perspective view of a suspension arrangement 910 in accordance with some embodiments. The suspension arrangement 910 may be equivalent to the suspension arrangement 110 described above with reference to Figure 2, except in that the suspension arrangement 910 comprises two tensile rod insulators 748, in place of two of the rigid suspending insulators 116. Moreover, the rotational dampers 114 are arranged at the second coupling devices 118, i.e., at the coupling devices connecting the rigid suspending insulators 116 to the high voltage valve unit 150.

The person skilled in the art realizes that the present invention by no means is limited to the preferred embodiments described above. On the contrary, many modifications and variations are possible within the scope of the appended claims.

Although features and elements are described above in particular combinations, each feature or element can be used alone without the other features and elements or in various combinations with or without other features and elements.

Additionally, variations to the disclosed embodiments can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain features are recited in mutually different dependent claims does not indicate that a combination of these features cannot be used to advantage.

## Claims

1. A suspension arrangement (110) for suspending a high voltage valve unit (150) from a load carrying support structure (12), the suspension arrangement comprising:
a rigid suspending insulator (116) configured to suspend the valve unit from the support structure;
a first coupling device (112) configured to connect the rigid suspending insulator to the support structure and configured to allow rotation of the rigid suspending insulator relative the support structure about two first perpendicular and substantially horizontal axes (A1, A2); and
a second coupling device (118) configured to connect the rigid suspending insulator to the valve unit and configured to allow rotation of the valve unit relative the rigid suspending insulator about structure about two second perpendicular and substantially horizontal axes (A1, A2);
at least one rotational damper (114), wherein the at least one rotational damper is arranged at the first coupling device to damp relative rotations between the rigid suspending insulator and the support structure about the two first axes, or the at least one rotational damper is arranged at the second coupling device to damp relative rotations between the valve unit and the rigid suspending insulator about the two second axes.

2. The suspension arrangement of claim 1, wherein the first coupling device comprises a first universal joint (312) and the second coupling device comprises a second universal joint.

3. The suspension arrangement of claims 1, wherein the first coupling device comprises a first ball joint and wherein the second coupling device comprises a second ball joint.

4. The suspension arrangement of any one of the preceding claims, wherein the rotational damper is separate from the first coupling device and arranged in parallel with the first coupling device, or the rotational damper is separate from the second coupling device and arranged in parallel with the second coupling device.

5. The suspension arrangement of any one of claims 1-3, wherein the rotational damper is an integral part of the first coupling device or the second coupling device.

6. The suspension arrangement of any one of the preceding claims, wherein the rotational damper comprises a yield damper (414).

7. The suspension arrangement of any one of the preceding claims, wherein the rotational damper comprises a viscous damper (614).

8. The suspension arrangement of any one of the preceding claims, wherein the rotational damper comprises a friction damper (514).

9. The suspension arrangement of any one of the preceding claims, wherein the rigid suspending insulator is a post insulator.

10. The suspension arrangement of claim 1, wherein:
at least one of the first coupling device and the second coupling device comprises a universal joint (412) connected to a first support member (434) and a second support member (436), the universal joint allowing relative rotation between the two support members about a first axis (A1) and a second axis (A2) perpendicular to the first axis;
wherein the at least one rotational damper comprises four damping elements (432a, 432b), each damping element comprising a base section (433a, 433b), a connector section (437a, 437b), and a yielding section (435a, 435b) extending between the base section and the connector section, the yielding section being configured to plastically deform by a relative rotation between the base section and the connector section;
wherein a first pair (432a) of the damping elements are arranged on opposite sides of the universal joint along the first axis, wherein the base sections of each of the first pair of damping elements are fastened to the first support member;
wherein a second pair (432b) of the damping elements are arranged on opposite sides of the universal joint along the second axis, wherein the base sections of each of the second pair of damping elements are fastened to the second support member; and
wherein the connector sections (437a) of each of the first pair of damping elements are fastened to the connector sections (437b) of each of the second pair of damping elements such that the connector sections of the four damping elements form a rigid loop around the universal joint.

11. The suspension arrangement of any one of the preceding claims, wherein:
the rigid suspending insulator is one of at least two rigid suspending insulators configured to suspend the valve unit from the support structure;
each rigid suspending insulator is connected to a first coupling device configured to connect the rigid suspending insulator to the support structure and configured to allow rotation of the rigid suspending insulator relative the support structure about two first separate and substantially horizontal axes;
each rigid suspending insulator is connected to a second coupling device configured to connect the rigid suspending insulator to the valve unit and configured to allow rotation of the valve unit relative the rigid suspending insulator about two second separate and substantially horizontal axes; and
for each rigid suspending insulator, at least one rotational damper is arranged at the first coupling device to damp relative rotations between the rigid suspending insulator and the support structure about the two first axes, or at the second coupling device to damp relative rotations between the valve unit and the rigid suspending insulator about the two second axes.

12. The suspension arrangement of claim 11, wherein the suspension arrangement comprises four rigid suspending insulators configured to suspend the valve unit from the support structure.

13. The suspension arrangement of claim 11 or 12, wherein:
for each rigid suspending insulator, the at least one rotational damper is arranged at the first coupling device to damp relative rotations between the rigid suspending insulator and the support structure about the two first axes; and/or
for each rigid suspending insulator, the at least one rotational damper is arranged at the second coupling device to damp relative rotations between the valve unit and the rigid suspending insulator about the two second axes.

14. The suspension arrangement of any one of the preceding claims further comprising at least one further suspending insulator configured to suspend the valve unit from the support structure, wherein the at least one further suspending insulator is arranged without a corresponding rotational damper.

15. A high voltage system (100) comprising:
a high voltage valve unit (150); and
a suspension arrangement (110) according to any one of the preceding claims for suspending the valve unit from a load carrying support structure (12).
